(19) Europäisches Patentamt
European Patent Office
Office européen des brevets

(11) **EP 2 302 406 B1**

(12) **EUROPEAN PATENT SPECIFICATION**

(45) Date of publication and mention
of the grant of the patent:
**03.10.2012 Bulletin 2012/40**

(51) Int Cl.:
***G01R 33/09*** *(2006.01)*     ***G01R 33/00*** *(2006.01)*

(21) Application number: **10009711.2**

(22) Date of filing: **16.09.2010**

(54) **Magnetic sensor and manufacturing method thereof**

Magnetischer Sensor und zugehöriges Herstellungsverfahren

Capteur magnétique et son procédé de fabrication

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **18.09.2009 JP 2009217926**

(43) Date of publication of application:
**30.03.2011 Bulletin 2011/13**

(73) Proprietor: **TDK Corporation
Tokyo 103-8272 (JP)**

(72) Inventors:
• **Ohta, Naoki
Tokyo 103-8272 (JP)**
• **Terunuma, Koichi
Tokyo 103-8272 (JP)**
• **Miura, Satoshi
Tokyo 103-8272 (JP)**
• **Sakai, Masanori
Tokyo 103-8272 (JP)**
• **Yamazaki, Hiroshi
Tokyo 103-8272 (JP)**

(74) Representative: **Müller - Hoffmann & Partner
Patentanwälte
Innere Wiener Strasse 17
81667 München (DE)**

(56) References cited:
**US-A1- 2009 190 272     US-B1- 6 771 472**

**Description**

BACKGROUND OF THE INVENTION

Field of the Invention

The invention relates to a magnetic sensor capable of detecting a change in a magnetic field highly sensitively, and to a manufacturing method thereof.

Description of the Related Art

In general, when accurately detecting a minute control current flowing in a circuit of a control device, a method is used, where resistors are connected in series in the circuit and a voltage drop of the resistors is measured. However, this may cause some adverse effect on a control system, since a load different from that of the control system is applied. Thus, a method which performs indirect measurement by detecting a gradient of a current magnetic field generated by a control current has been used. For example, the indirect measurement method is achieved by winding a measurement line around a toroidal core, and supplying a control current to the measurement line, to detect a magnetic flux generated in a central part of the toroidal core with a Hall element.

It has been pointed out, however, that a current sensor which achieves the method described above has disadvantages, in that a reduction in size is difficult, and that such a current sensor is insufficient in terms of a linearity or a high-frequency response property, and so forth. To address these issues, a magnetic sensor has been proposed, in which a giant magnetoresistive element (which may be hereinafter referred to as a "GMR element") exhibiting a giant magnetoresistive effect is disposed in an induction magnetic field generated by a control current, and a gradient of the induction magnetic field is detected, as disclosed in US Patent No. 5,621,377, for example. Also, in this connection, a technology which utilizes a magnetic sensor provided with a GMR element to detect a flaw on a surface of a metal substrate, for example, is known. The magnetic sensor utilizing the GMR element makes it possible to relatively improve a detection sensitivity and a response property, and to obtain detection characteristics which are stable even in a temperature variation. In particular, when the detection of the induction magnetic field is performed with a Wheatstone bridge circuit which includes four GMR elements, a sensitivity and an accuracy can be further improved as compared with a case where only one GMR element is used.

On the other hand, the Wheatstone bridge circuit should be so configured that two GMR elements (i.e., first and second GMR elements) among the four GMR elements exhibit a behavior opposite to that of the remaining two GMR elements (i.e., third and fourth GMR elements). That is, a magnetization of a pinned layer in each of the first and the second GMR elements and a magnetization of a pinned layer in each of the third and the fourth GMR elements should be fixed in directions opposite to each other, for example. Also, it is desirable that the four GMR elements structuring the Wheatstone bridge circuit each have a mutually-uniform magnetic property as much as possible. In view of such circumstances, the applicant (the assignee) of this application has previously proposed a magnetic sensor, in which a plurality of GMR elements are collectively formed on the same wafer, then both the GMR elements and the wafer are cut out individually, and four GMR elements, which are selected among those GMR elements, are then so disposed on a substrate as to be appropriately oriented on the substrate, as disclosed, for example, in Japanese Unexamined Patent Application Publication No. 2008-111801. For example, JP2003-502674A (Published Japanese Translation of PCT Application) proposes a method of manufacturing a magnetic sensor, in which two GMR elements are deposited under a magnetic field having a first direction, and remaining two GMR elements are deposited under a magnetic field having an opposite direction to the first direction. Also, JP2003-502876A (Published Japanese Translation of PCT Application) proposes a method in which an annealing process (a process of irradiating a laser pulse, an electron beam, or the like in this method) is separately performed under an application of an external magnetic field in a predetermined direction to allow magnetizations of pinned layers in the four GMR elements to be appropriately oriented, respectively, for example.

From US 6,771,472 B1, a structure is known, which shall be used to achieve thermally stable high sensitivity and linear range in bridge GMR sensor using SAF magnetic alignments. A respective magnetic sensor has a first opposing pair and a second opposing pair of resistive elements configured in a wheat stone bridge, wherein the resistive elements are synthetic entire ferromagnetic GMR sensor having a reference layer and a pinned layer of different thicknesses, wherein the first opposing pair has a net magnetic moment that is opposite to that of the second opposing pair, and wherein the first opposing pair has a thicker reference layer than pinned layer, and the second opposing pair has a thicker pinned layer than a reference layer.

In US 2009/0190272 A1, a magnetoresistive device of the CPP type, and a respective magnetic disc system are disclosed. The magnetoresistive device comprises a magnetoresistive unit, and a first shield layer and a second shield layer located and formed such that the magnetoresistive unit is sandwiched between them with a sense current applied in a stacking direction, wherein said magnetoresistive unit comprises a non-magnetic intermediate layer, and a first ferromagnetic layer and a second ferromagnetic layer stacked and formed such that said non-magnetic intermediate layer is interposed between them, wherein the first shield layer and a second shield layer is controlled by a magnetization direction control means in terms of magnetization direction, and the second ferromagnetic layer receives action such that there is an entire parallel magnetization state created, in which mutual magnetizations are in opposite directions, under the influence of magnetic actions of the first shield layer and the second shield layer.

The above objects are solved by the claimed matter according to the independent claims.

SUMMARY OF THE INVENTION

A magnetic sensor described in JP2008-111801A has a somewhat complicated manufacturing process, and has room for improvement in productivity. A magnetic sensor or the like disclosed in JP2003-502674A has drawbacks in that a manufacturing process is cumbersome, and thus productivity is disadvantageous. In particular, JP2003-502674A has a problem in that an orientation of a magnetization of a pinned layer in each GMR element formed in advance may be influenced by a magnetic field in an opposite direction which is applied in subsequent formation of remaining GMR elements, and thereby the magnetizations of the GMR elements may be deviated from their predetermined orientations. Also, a method described in JP2003-502876A requires special facilities such as a laser irradiation apparatus, an electron beam irradiation apparatus and so forth, and yet still disadvantageous in productivity.

It is therefore desirable to provide a magnetic sensor having a compact configuration and superior detection performance of a magnetic field, and which is yet easily manufacturable. It is also desirable to provide a method of manufacturing a magnetic sensor capable of manufacturing such magnetic sensor in a simplified fashion.

A magnetic sensor according to an embodiment includes: a first magnetoresistive element and a second magnetoresistive element each including, in order: a magnetization free layer in which orientation of magnetization changes in response to a signal magnetic field; a nonmagnetic spacing layer; a magnetization pinned layer having one or more first layers of a first group of ferromagnetic layers, and one or more second layers of a second group of ferromagnetic layers, the first layer and the second layer being stacked alternately with a nonmagnetic coupling layer in between, and being so antiferromagnetically coupled to each other as to have magnetizations which are opposite in direction to each other; and an antiferromagnetic layer pinning orientation of magnetization in the one or more first layers and orientation of magnetization in the one or more second layers. The magnetization pinned layer in the first magnetoresistive element includes the first layers, which are one more in number than the number of the one or more second layers, and the magnetization pinned layer in the second magnetoresistive element includes the one or more second layers and the one or more first layers in order from the magnetization free layer, and the number of the one or more first layers equals the number of the one or more second layers.

A magnetic sensor according to an embodiment includes: a first magnetoresistive element, a second magnetoresistive element, a third magnetoresistive element, and a fourth magnetoresistive element each including, in order: a magnetization free layer in which orientation of magnetization changes in response to a signal magnetic field; a nonmagnetic spacing layer; a magnetization pinned layer having one or more first layers of a first group of ferromagnetic layers, and one or more second layers of a second group of ferromagnetic layers, the first layer and the second layer being stacked alternately with a nonmagnetic coupling layer in between, and being so antiferromagnetically coupled to each other as to have magnetizations which are opposite in direction to each other; and an antiferromagnetic layer pinning orientation of magnetization in the one or more first layers and orientation of magnetization in the one or more second layers. The magnetization pinned layer in each of the first magnetoresistive element and the third magnetoresistive element includes the first layers, which are one more in number than the number of the one or more second layers. The magnetization pinned layer in each of the second magnetoresistive element and the fourth magnetoresistive element includes the one or more second layers and the one or more first layers in order from the magnetization free layer, in which the number of the one or more first layers equals the number of the one or more second layers. A first end of the first magnetoresistive element and a first end of the second magnetoresistive element are connected together in a first connection point, a first end of the third magnetoresistive element and a first end of the fourth magnetoresistive element are connected together in a second connection point, a second end of the first magnetoresistive element and a second end of the fourth magnetoresistive element are connected together in a third connection point, and a second end of the second magnetoresistive element and a second end of the third magnetoresistive element are connected together in a fourth connection point, to establish a bridge circuit.

In the magnetic sensor according to the embodiments, the magnetization pinned layer having the one or more first layers of the first group of ferromagnetic layers and the one or more second layers of the second group of ferromagnetic layers, in which the first layer and the second layer are stacked alternately with the nonmagnetic coupling layer in between and so antiferromagnetically coupled each other as to have the magnetizations opposite in direction to each other, is provided to be adjacent to the antiferromagnetic layer. Also, in the first magnetoresistive element (or the first and the third magnetoresistive elements), the magnetization pinned layer includes the first layers, which are one more in number than the number of the one or more second layers. On the other hand, in the second magnetoresistive element (or the second and the fourth magnetoresistive elements), the number of the one or more first layers and the number of the one or more second layers are the same. Further, in the first magnetoresistive element (or the first and the third magnetoresistive elements), the first layer is positioned nearer to the magnetization free layer than the second layer, whereas in the second magnetoresistive element (or the second and the fourth magnetoresistive elements), the second layer is positioned nearer to the magnetization free layer than the first layer. Thus, the first magnetoresistive element (or the first and the third magnetoresistive elements), and the second magnetoresistive element (or the second and the fourth magnetoresistive elements) exhibit resistance changes in directions (i.e., increasing/decreasing direction) opposite to each other in response to the signal magnetic field. As used herein, the term "resistance change" refers to an increase or decrease in resistance. In other words, the wording "exhibit resistance changes in directions opposite to each other" refers to a relationship where, for example, when a resistance of the first magnetoresistive element increases in response to application of the signal magnetic field, a resistance of the second magnetoresistive element decreases, and vice versa. In the magnetic sensor according to the embodiments described above, a thermal annealing process may be performed under application of a magnetic field in one given direction, to allow the magnetizations in one or more first ferromagnetic layers and the one or more second ferromagnetic layers in each of the magnetization pinned layers to have predetermined orientations by one operation.

Advantageously, the first magnetoresistive element and the second magnetoresistive element (or the first magnetoresistive element to the fourth magnetoresistive element) are provided on a same substrate.

A method of manufacturing a magnetic sensor according to an embodiment includes the steps of: selectively forming, on a substrate, a first magnetoresistive element and a second magnetoresistive element in respective regions different from each other, the first magnetoresistive element and the second magnetoresistive element each including, in order: an antiferromagnetic layer; a magnetization pinned layer having a plurality of ferromagnetic layers which are antiferromagnetically coupled to each other with a nonmagnetic coupling layer in between; a nonmagnetic spacing layer; and a magnetization free layer in which orientation of magnetization changes in response to a signal magnetic field; and heating the first magnetoresistive element and the second magnetoresistive element while applying thereto a magnetic field in one given direction, thereby allowing orientation of magnetization in all of the plurality of ferromagnetic layers of the magnetization pinned layers in the first magnetoresistive element and the second magnetoresistive element to be secured by one operation, wherein the magnetization pinned layer in the first magnetoresistive element is so formed as to include the odd number of the ferromagnetic layers, and the magnetization pinned layer in the second magnetoresistive element is so formed as to include the even number of the ferromagnetic layers.

In the method of manufacturing the magnetic sensor according to the embodiment, the magnetization pinned layer in the first magnetoresistive element is so formed as to include the odd number of the ferromagnetic layers, and the magnetization pinned layer in the second magnetoresistive element is so formed as to include the even number of the ferromagnetic layers. Thus, the orientation of the magnetization in the ferromagnetic layer, located nearest to the magnetization free layer in the magnetization pinned layer of the first magnetoresistive element, becomes opposite to the orientation of the magnetization in the ferromagnetic layer, located nearest to the magnetization free layer in the magnetization pinned layer of the second magnetoresistive element. Thus, the first magnetoresistive element and the second magnetoresistive element exhibit resistance changes in directions (i.e., increasing/decreasing direction) opposite to each other in response to the signal magnetic field.

Advantageously, the magnetization pinned layer in the first magnetoresistive element is formed to have a five-layer structure including a first ferromagnetic layer having magnetization in a first direction as one of the plurality of ferromagnetic layers, a first coupling layer, a second ferromagnetic layer having magnetization in a second direction opposite to the first direction as another one of the plurality of ferromagnetic layers, a second coupling layer, and a third ferromagnetic layer having magnetization in a first direction as still another one of the plurality of ferromagnetic layers, and the magnetization pinned layer in the second magnetoresistive element is formed to have a three-layer structure including a fourth ferromagnetic layer having magnetization in a second direction as still another one of the plurality of ferromagnetic layers, a third coupling layer, and a fifth ferromagnetic layer having magnetization in a first direction as still another one of the plurality of ferromagnetic layers, which are arranged in order from the magnetization free layer.

According to the magnetic sensor of the embodiments, the numbers of the first layers and the second layers, which are so antiferromagnetically coupled to each other as to have the magnetizations opposite in direction to each other, are adjusted to allow the first magnetoresistive element (or the first and the third magnetoresistive elements) and the second magnetoresistive element (or the second and the fourth magnetoresistive elements) to exhibit the resistance changes in directions (i.e., increasing/decreasing direction) opposite to each other in response to the signal magnetic field. Thus, it is possible to achieve the magnetic sensor having superior detection performance of a magnetic field while ensuring a compact configuration and which is yet easily manufacturable, by connecting the first and the second magnetoresistive elements in a half-bridge configuration or connecting the first to the fourth magnetoresistive elements in a full-bridge configuration. Also, according to the method of manufacturing the magnetic sensor of the embodiment, it is possible to manufacture the magnetic sensor with high degree of accuracy in a simplified fashion.

It is to be understood that both the foregoing general description and the following detailed description are exemplary, and are intended to provide further explanation of the invention as claimed.

BRIEF DESCRIPTION OF THE DRAWINGS

The accompanying drawings are included to provide a further understanding of the invention, and are incorporated in and constitute a part of this specification. The drawings illustrate embodiments of the invention and, together with the specification, serve to explain the principles of the invention.

FIG. 1 is a plan view illustrating an overall configuration of a magnetic sensor according to an embodiment of the invention.

FIG. 2 is an enlarged perspective view illustrating a main configuration of the magnetic sensor illustrated in FIG. 1.

FIG. 3A and FIG. 3B are cross-sectional views illustrating laminated structures of stacked bodies included in first to fourth MR elements illustrated in FIG. 2.

FIG. 4 is a circuit diagram illustrating a configuration of a magnetic field detecting circuit in the magnetic sensor illustrated in FIG. 1.

FIG. 5 is a cross-sectional view illustrating a process in a method of manufacturing the magnetic sensor illustrated in FIG. 1.

FIG. 6 is a cross-sectional view illustrating a process subsequent to that in FIG. 5.

FIG. 7A and FIG. 7B are a plan view and a cross-sectional view illustrating a process subsequent to that in FIG. 6, respectively.

FIG. 8A and FIG. 8B are a plan view and a cross-sectional view illustrating a process subsequent to that in FIGs. 7A and 7B, respectively.

FIG. 9A and FIG. 9B are a plan view and a cross-sectional view illustrating a process subsequent to that in FIGs. 8A and 8B, respectively.

FIG. 10A and FIG. 10B are a plan view and a cross-sectional view illustrating a process subsequent to that in FIGs. 9A and 9B, respectively.

FIG. 11A and FIG. 11B are a plan view and a cross-sectional view illustrating a process subsequent to that in FIGs. 10A and 10B, respectively.

FIG. 12A and FIG. 12B are a plan view and a cross-sectional view illustrating a process subsequent to that in FIGs. 11A and 11B, respectively.

FIG. 13A and FIG. 13B are a plan view and a cross-sectional view illustrating a process subsequent to that in FIGs. 12A and 12B, respectively.

FIG. 14A and FIG. 14B are a plan view and a cross-sectional view illustrating a process subsequent to that in FIGs. 13A and 13B, respectively.

FIG. 15A and FIG. 15B are a plan view and a cross-sectional view illustrating a process subsequent to that in FIGs. 14A and 14B, respectively.

FIG. 16A and FIG. 16B are a plan view and a cross-sectional view illustrating a process subsequent to that in FIGs. 15A and 15B, respectively.

DETAILED DESCRIPTION OF THE PREFERRED EMBODIMENTS

Hereinafter, an embodiment of the invention will be described in detail with reference to the accompanying drawings.

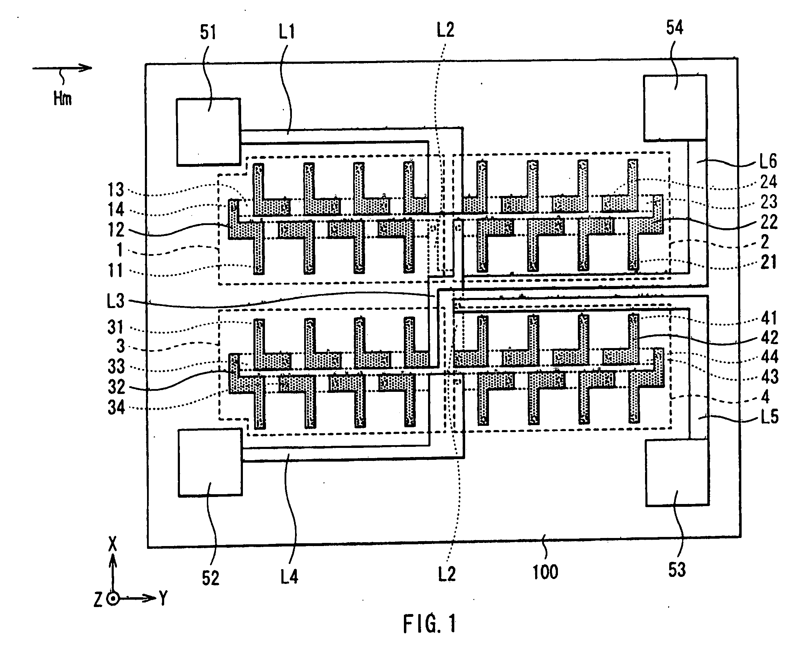

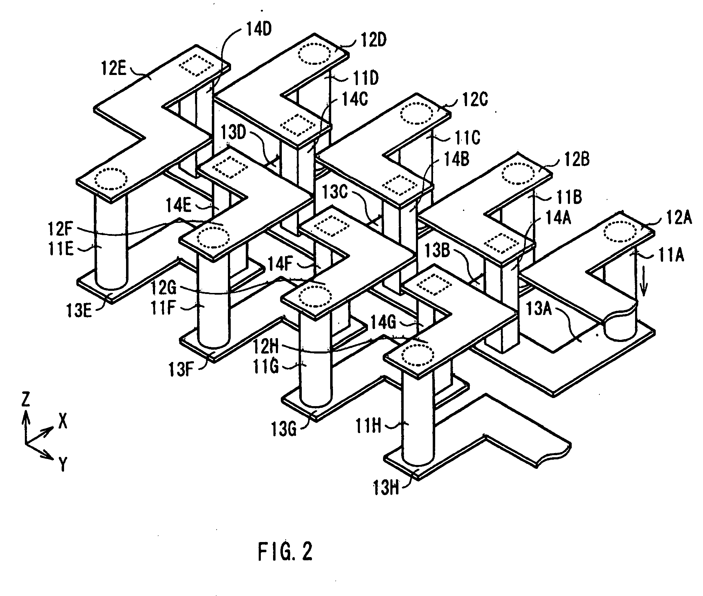

First, a configuration of a magnetic sensor according to one embodiment of the invention will be described with reference to FIGs. 1 to 16B. FIG. 1 is a plan view illustrating an overall configuration of the magnetic sensor according to the embodiment. FIG. 2 is an enlarged perspective view illustrating a main configuration of the magnetic sensor.

The magnetic sensor according to this embodiment includes first to fourth magnetoresistive (MR: Magneto-Resistive effect) elements 1 to 4 (hereinafter may be simply referred to as "MR elements"), pads 51 to 54, interconnections L1 to L6, and a difference detector AMP (described later), and so forth, which are provided on a substrate 100. The magnetic sensor may detect a magnitude of a signal magnetic field Hm applied in a plus Y direction, for example. More specifically, the magnetic sensor may be used as a current sensor, which is disposed near an unillustrated conductor extending, for example, in an X-axis direction and which detects an induction magnetic field induced by a current flowing in the conductor as the signal magnetic field Hm to indirectly measure that current. For example, the pad 51 is connected to a power source Vcc which will be described later, and the pad 52 is grounded. Each of the pads 53 and 54 is connected to an input terminal of the difference detector AMP, for example.

The substrate 100 may be a rectangular member which supports the magnetic sensor as a whole, and may be configured of ceramics. The ceramics of the substrate 100 can be glass, silicon (Si), aluminum oxide ($Al_2O_3$), AlTiC ($Al_2O_3$-TiC), or other suitable material. An insulating layer (not illustrated) containing ceramics such as silicon oxide

(SiO$_2$), aluminum oxide, and so forth may be provided to cover the substrate 100.

The first to the fourth MR elements 1 to 4 include a plurality of stacked bodies 11,21,31, and 41, respectively. In the exemplary embodiment illustrated in FIGs. 1 and 2, the first to the fourth MR elements 1 to 4 include eight stacked bodies 11, 21, 31, and 41, respectively, although it is not limited thereto. When the signal magnetic field Hm is applied, a resistance of each of the first and the third MR elements 1 and 3 changes in the same direction (i.e., the same increasing/decreasing direction) in response to the signal magnetic field Hm, and a resistance of each of the second and the fourth MR elements 2 and 4 changes in a direction (i.e., an increasing/decreasing direction) opposite to that of the first and the third MR elements 1 and 3 in response to the signal magnetic field Hm. Note that the first to the fourth MR elements 1 to 4 each have a substantially similar configuration to one another, except for a configuration of the stacked bodies 11, 21, 31, and 41. In the following, the description will be made based on the first MR element 1 on behalf of the first to the fourth MR elements 1 to 4 with reference mainly to FIG. 2, except for the description on the stacked bodies 11, 21, 31, and 41.

Referring to FIG. 2, the first MR element 1 has a configuration in which the plurality of stacked bodies 11 (stacked bodies 11A to 11H) are disposed in a sandwich-like manner between top electrodes 12 (top electrodes 12A to 12H) and bottom electrodes 13 (bottom electrodes 13A to 13H) in a thickness direction (i.e., a stack direction). The stacked body 11 connects one end of the top electrode 12 and one end of the bottom electrode 13 therethrough. The other end the top electrode 12, whose one end is connected to the stacked body 11, is connected, through a columnar connector 14 (connectors 14A to 14H), to the other end of the bottom electrode 13, whose one end is connected to the adjacent stacked body 11. Thus, all of the stacked bodies 11A to 11H are connected or combined in series to one another through the top electrodes 12A to 12H, the bottom electrodes 13A to 13H, and the connectors 14A to 14H. The top electrode 12A located at one end of the first MR element 1 is connected with the stacked body 11A, and is also connected to the interconnection L1 illustrated in FIG. 1. The bottom electrode 13H located at the other end of the first MR element 1 is connected with the stacked body 11H, and is also connected to the interconnection L2 illustrated in FIG. 1. With this configuration, a current supplied from the interconnection L1 flows successively through the stacked bodies 11A to 11H to the interconnection L2. At this time, the current flows in each of the stacked bodies 11A to 11 H in a direction going from the top electrodes 12 to the bottom electrodes 13 (i.e., in a minus Z direction). Each of the top electrodes 12, the bottom electrodes 13, and the connectors 14 is configured of a nonmagnetic material having high-electrical conductivity, which can be copper (Cu), or other suitable material.

As illustrated in FIG. 1, the second to the fourth MR elements 2 to 4 are provided with top electrodes 22, 32, and 42, bottom electrodes 23, 33, and 43, and connectors 24, 34, and 44, corresponding to the top electrodes 12, the bottom electrodes 13, and the connectors 14 in the first MR element 1, respectively. In the second MR element 2, the top electrode 22 located at one end of the second MR element 2 is connected to the interconnection L1, and the bottom electrode 23 located at the other end of the second MR element 2 is connected to the interconnection L3. In the third MR element 3, the top electrode 32 located at one end of the third MR element 3 is connected to the interconnection L3, and the bottom electrode 33 located at the other end of the third MR element 3 is connected to the interconnection L4. In the fourth MR element 4, the top electrode 42 located at one end of the fourth MR element 4 is connected to the interconnection L2, and the bottom electrode 43 located at the other end of the fourth MR element 4 is connected to the interconnection L4. Also, the interconnection L2 is connected to the pad 53 through the interconnection L5, and the interconnection L3 is connected to the pad 54 through the interconnection L6.

Each of the interconnections L1 to L6 is configured of a nonmagnetic material having high-electrical conductivity, which can be copper (Cu), or other suitable material. The interconnections L1 and L3 to L6 are located on a same level as the top electrodes 12, 22, 32, and 42, and the interconnection L2 is located on a same level as the bottom electrodes 13, 23, 33, and 43, for example. Although the interconnections L2 and L5 are located on the different levels from each other, the interconnections L2 and L5 are joined each other in the thickness direction through a columnar member (not illustrated) configured of copper, for example.

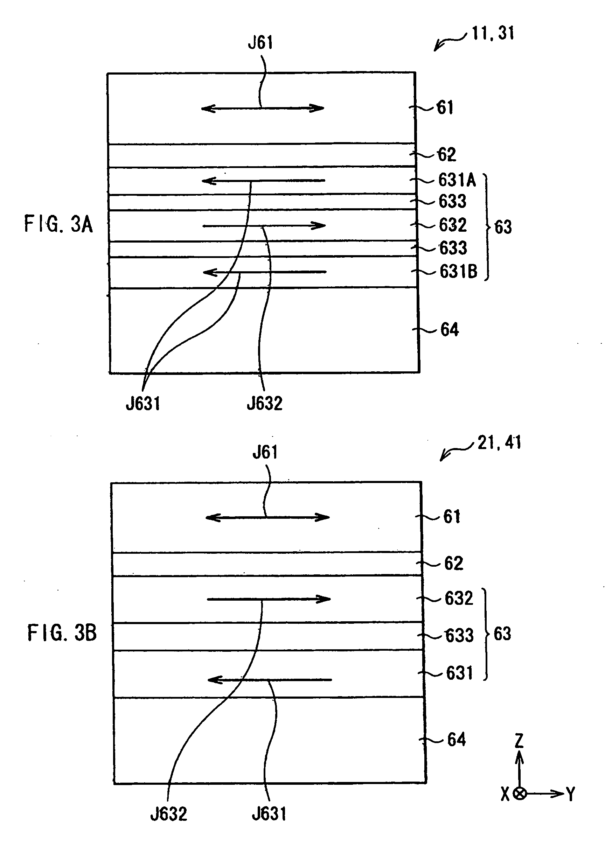

Now, a configuration of the stacked bodies 11, 21, 31, and 41 will be described with reference to FIGs. 3A and 3B. FIG. 3A illustrates a schematic cross-sectional configuration of the stacked bodies 11 and 31, whereas FIG. 3B illustrates a schematic cross-sectional configuration of the stacked bodies 21 and 41. Each of the stacked bodies 11, 21, 31, and 41 includes a magnetization free layer 61, an spacing layer 62, a magnetization pinned layer 63, and an antiferromagnetic layer 64 in this order from a side on which the top electrodes 12, 22, 32, and 42 are provided. In one embodiment, an overcoat film may be so provided as to cover a surface of the magnetization free layer 61 facing the top electrodes 12, 22, 32, and 42 side. Also, in one embodiment, a seed layer may be provided between the antiferromagnetic layer 64 and the substrate 100.

The magnetization free layer 61 is a soft ferromagnetic layer in which a magnetization direction J61 changes in response to an external magnetic field such as the signal magnetic field, and has a magnetization easy axis in an X-axis direction, for example. The magnetization free layer 61 is configured of a cobalt-iron alloy (CoFe), a nickel-iron alloy (NiFe), a cobalt-iron-boron alloy (CoFeB), or other suitable material, for example.

The spacing layer 62 is a nonmagnetic tunnel barrier layer configured of a magnesium oxide (MgO), for example.

The spacing layer 62 has a thickness which is thin enough that a quantum mechanical tunneling current is possible to pass therethrough. The tunnel barrier layer configured of MgO is obtained by a sputtering process involving an MgO target, an oxidation process of a magnesium (Mg) thin-film, a reactive sputtering process involving a sputtering of magnesium under an oxygen atmosphere, or other suitable process. Other than MgO, a material of the spacing layer 62 can be an oxide or a nitride of aluminum (Al), tantalum (Ta), hafnium (Hf) or the like.

The magnetization pinned layer 63 has a synthetic structure in which a first ferromagnetic layer 631 and a second ferromagnetic layer 632 are stacked alternately with a nonmagnetic coupling layer 633 in between, and are so antiferromagnetically coupled to each other as to have magnetizations which are opposite in direction to each other. The magnetization pinned layer 63 has one or more first ferromagnetic layers 631 belonging to a first group of ferromagnetic layers, and one or more second ferromagnetic layers 632 belonging to a second group of ferromagnetic layers. It is to be noted that the number of first ferromagnetic layers 631 and the number of second ferromagnetic layers 632 structuring the magnetization pinned layer 63 differ between the magnetization pinned layer 63 in the stacked bodies 11 and 31 and the magnetization pinned layer 63 in the stacked bodies 21 and 41.

For example, the magnetization pinned layer 63 in each of the stacked bodies 11 and 31 includes the first ferromagnetic layers 631, which are larger in number by one layer than the second ferromagnetic layer 632. That is, the magnetization pinned layer 63 in each of the stacked bodies 11 and 31 has a five-layer structure including a first ferromagnetic layer 631A (a first ferromagnetic layer as one of the first ferromagnetic layers 631 of the first group), the coupling layer 633 (a first coupling layer), the second ferromagnetic layer 632 (a second ferromagnetic layer as the second ferromagnetic layer 632 of the second group), the coupling layer 633 (a second coupling layer), and a first ferromagnetic layer 631B (a third ferromagnetic layer as another one of the first ferromagnetic layers 631 of the first group), which are stacked in order from the magnetization free layer 61 side. An orientation of a magnetization J631 of the first ferromagnetic layer 631 (i.e., the first ferromagnetic layers 631A and 631B) is antiparallel to an orientation of a magnetization J632 of the second ferromagnetic layer 632 in a lamination plane. It should be understood that, although FIG. 3A illustrates an example where the magnetization pinned layer 63 in each of the stacked bodies 11 and 31 includes the five-layer structure, the configuration of the magnetization pinned layer 63 is not limited thereto. The number of layers in the magnetization pinned layer 63 in each of the stacked bodies 11 and 31 can be optional as long as the number of the first ferromagnetic layers 631 is larger by one layer than the number of the second ferromagnetic layers 632, such as a nine-layer structure including the coupling layers 633.

On the other hand, the magnetization pinned layer 63 in each of the stacked bodies 21 and 41 has a configuration in which the second ferromagnetic layer 632 (a fourth ferromagnetic layer as the second ferromagnetic layer 632 of the second group) and the first ferromagnetic layer 631 (a fifth ferromagnetic layer as the first ferromagnetic layer 631 of the first group) are stacked alternately in order from the magnetization free layer 61 side with the coupling layer 633 (a third coupling layer) in between, and in which the number of the first ferromagnetic layers 631 is same as (i.e., equals) the number of the second ferromagnetic layers 632. That is, the magnetization pinned layer 63 in each of the stacked bodies 21 and 41 has the synthetic structure in which the first ferromagnetic layer 631 and the second ferromagnetic layer 632 are so antiferromagnetically coupled to each other as to have magnetizations opposite in direction to each other. It should be understood that, although FIG. 3B illustrates an example where the magnetization pinned layer 63 in each of the stacked bodies 21 and 41 includes three-layer structure in which one layer of the first ferromagnetic layer 631 and one layer of the second ferromagnetic layer 632 are so provided as to sandwich the coupling layer 633 in between, the configuration of the magnetization pinned layer 63 is not limited thereto. The magnetization pinned layer 63 in each of the stacked bodies 21 and 41 may include a plurality of first ferromagnetic layers 631 and a plurality of second ferromagnetic layers 632. That is, the number of layers in the magnetization pinned layer 63 in each of the stacked bodies 21 and 41 can be optional, as long as the second ferromagnetic layer 632 is positioned nearer to the magnetization free layer 61 than the first ferromagnetic layer 631, and as long as the number of the first ferromagnetic layers 631 and the number of the second ferromagnetic layers 632 are the same, such as a seven-layer structure including the coupling layers 633.

According to this embodiment, the magnetization pinned layer 63 in each of the stacked bodies 11 and 31 includes, on a side nearest to the magnetization free layer 61, the first ferromagnetic layer 631 having the magnetization J631 pinned in a minus Y direction, whereas the magnetization pinned layer 63 in each of the stacked bodies 21 and 41 includes, on a side nearest to the magnetization free layer 61, the second ferromagnetic layer 632 having the magnetization J632 pinned in a plus Y direction. Thus, the stacked bodies 11 and 31, and the stacked bodies 21 and 41 exhibit resistance changes in directions (i.e., increasing/decreasing direction) opposite to each other in response to the signal magnetic field Hm. That is, in the stacked bodies 11 and 31, the magnetization J61 is oriented in the direction antiparallel to the direction of the magnetization J631 to have a high resistance state, whereas in the stacked bodies 21 and 41, the magnetization J61 is oriented in the direction parallel to the direction of the magnetization J632 to have a low resistance state, when the signal magnetic field Hm in the plus Y direction is applied, for example. Therefore, in the magnetic sensor according to this embodiment, the resistance of each of the first and the third MR elements 1 and 3 indicates a change in the orientation opposite to the orientation indicated by the resistance of each of the second and the fourth MR elements 2 and 4 in application of the signal magnetic field Hm. Incidentally, it is preferable, but not required, that a sum of a total magnetic moment in all of the first ferromagnetic layers 631 and a sum of a total magnetic moment in all of the second ferromagnetic layers 632 both be equal between the magnetization pinned layer 63 in the stacked bodies 11, 31 and the magnetization pinned layer 63 in the stacked bodies 21, 42, since this improves a detection accuracy for the magnetic sensor. As used herein, the term "total magnetic moment" refers to a product of a "magnetic moment per unit volume" of respective materials structuring the ferromagnetic layers thereof and a volume of the ferromagnetic layers thereof (i.e., the "magnetic moment per unit volume" multiplied by the "volume").

The first ferromagnetic layer 631 and the second ferromagnetic layer 632 are each configured of a ferromagnetic material, which can be cobalt (Co), a cobalt-iron alloy (CoFe), a cobalt-iron-boron alloy (CoFeB), or other suitable material. The coupling layer 633 is configured of a nonmagnetic material having high-electrical conductivity, which can be ruthenium (Ru), or other suitable material. The magnetization pinned layer 63 in each of the stacked bodies 11 and 31 and the magnetization pinned layer 63 in each of the stacked bodies 21 and 41 respectively have the following preferred, but not required, configurations.

[Magnetization Pinned layer 63 in Stacked Bodies 11 and 31]

First ferromagnetic layer 631B: CoFe layer (1.5 nm thick)
Coupling layer 633: Ru layer (0.8 nm thick)
Second ferromagnetic layer 632: CoFe layer (3.0 nm thick)
Coupling layer 633: Ru layer (0.8 nm thick)
First ferromagnetic layer 631A: CoFe layer (2.0 nm thick)

[Magnetization Pinned layer 63 in Stacked Bodies 21 and 41]

First ferromagnetic layer 631: CoFe layer (2.5 nm thick)
Coupling layer 633: Ru layer (0.8 nm thick)
Second ferromagnetic layer 632: CoFe layer (2.0 nm thick)

The antiferromagnetic layer 64 is configured of an antiferromagnetic material, which can be a platinum-manganese alloy (PtMn), an iridium-manganese alloy (IrMn), or other suitable material. The antiferromagnetic layer 64 has a state in which a spin magnetic moment in a plus Y direction and a spin magnetic moment in a minus Y direction are completely offset each other, and acts to pin the orientation of the magnetization J631 of the first ferromagnetic layer 631 and the orientation of the magnetization J632 of the second ferromagnetic layer 632 in the adjacent magnetization pinned layer 63 in the plus Y direction or in the minus Y direction.

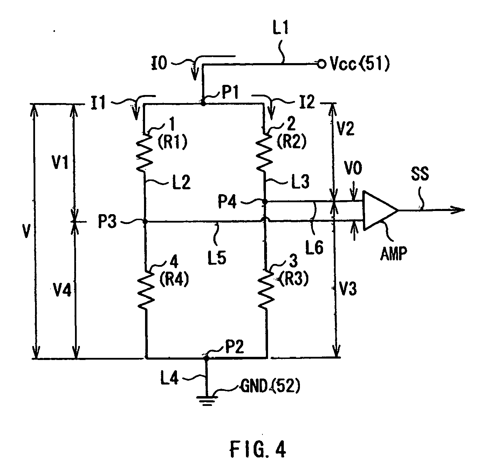

FIG. 4 schematically illustrates a configuration of a magnetic field detecting circuit in the magnetic sensor. One end of the first MR element 1 and one end of the second MR element 2 are connected together in a first connection point P1, and one end of the third MR element 3 and one end of the fourth MR element 4 are connected together in a second connection point P2. Further, the other end of the first MR element 1 and the other end of the fourth MR element 4 are connected together in a third connection point P3, and the other end of the second MR element 2 and the other end of the third MR element 3 are connected together in a fourth connection point P4, to establish a bridge circuit. The first connection point P1 is connected to the power source Vcc through the interconnection L1, and the second connection point P2 is grounded through the interconnection L4. The third connection point P3 and the fourth connection point P4 are connected to input terminals of the difference detector AMP through the interconnection L5 and the interconnection L6, respectively. The difference detector AMP detects a potential difference developed between the third connection point P3 and the fourth connection point P4 when a voltage is applied between the first connection point P1 and the second connection point P2 (i.e., a difference in a voltage drop generated in each of the first and the second MR elements 1 and 2), and outputs the detected potential difference as a difference signal SS.

Now, a detecting method, based on the difference signal SS, of the signal magnetic field Hm as a detection target by using the magnetic sensor according to this embodiment will be described.

Referring to FIG. 4, the description will be given first on a state where the signal magnetic field Hm is not applied. In the following, the resistances of the first to the fourth MR elements 1 to 4 when a read-out current 10 is caused to flow from the power source Vcc are referred to as r1 to r4, respectively. The read-out current 10 from the power source Vcc is divided into a read-out current I1 and a read-out current I2 in the first connection point P1. Thereafter, the read-out current I1, having passed through the first MR element 1 and the third MR element 3, and the read-out current I2, having passed through the second MR element 2 and the fourth MR element 4, are merged at the second connection point P2. Here, a potential difference V between the first connection point P1 and the second connection point P2 is expressed as follows.

$$V = I1 \times r4 + I1 \times r1 = I2 \times r3 + I2 \times r2$$

$$= I1 \, (r4 + r1) = I2 \, (r3 + r2) \qquad \qquad \text{Equation (1)}$$

Also, a potential V1 at the third connection point P3 and a potential V2 at the fourth connection point P4 are each expressed as follows.

$$V1 = V - V4$$

$$= V - I1 \times r4$$

$$V2 = V - V3$$

$$= V - I2 \times r3$$

Therefore, a potential difference V0 between the third connection point P3 and the fourth connection point P4 is expressed as follows.

$$V0 = V1 - V2$$

$$= (V - I1 \times r4) - (V - I2 \times r3)$$

$$= I2 \times r3 - I1 \times r4 \qquad \qquad \text{Equation (2)}$$

Here, a following Equation (3) is established from the Equation (1).

$$V0 = r3 \, / \, (r3 + r2) \times V - r4 \, / \, (r4 + r1) \times V$$

$$= \{ r3 \, / \, (r3 + r2) - r4 \, / \, (r4 + r1) \} \times V \qquad \qquad \text{Equation (3)}$$

In the bridge circuit described above, an amount of resistance change is obtained by measuring the potential difference V0 between the third and the fourth connection points P3 and P4 expressed by the Equation (3) when the signal magnetic field Hm is applied. Here, when assuming that the resistances r1 to r4 increase by change amounts ΔR1 to ΔR4 at the time when the signal magnetic field Hm is applied, respectively, that is, when resistances R1 to R4 at the time of the application of the signal magnetic field Hm are expressed as: R1 = r1 + ΔR1; R2 = r2 + ΔR2; R3 = r3 + ΔR3; and R4 = r4 + ΔR4, respectively, the potential difference V0 at the time when the signal magnetic field Hm is applied is expressed, from the Equation (3), as follows.

$$V0 = \{ (r3 + \Delta R3) \, / \, (r3 + \Delta R3 + r2 + \Delta R2) - (r4 + \Delta R4) \, / \, (r4$$

$$+ \Delta R4 + r1 + \Delta R1) \} \times V \qquad \qquad \text{Equation (4)}$$

As already described above, since, in the magnetic sensor according to this embodiment, the resistances R1 and R3 of the first and the third MR elements 1 and 3, and the resistances R2 and R4 of the second and the fourth MR elements 2 and 4, change in the directions opposite to each other, the change amount ΔR3 and the change amount ΔR2 offset each other, and the change amount ΔR4 and the change amount ΔR1 offset each other. Thus, there is hardly any increase in denominator in each term in the Equation (4) when comparing a state before the application of the signal magnetic field Hm and a state after the application of the signal magnetic field Hm. On the other hand, as for numerator in each term in the Equation (4), since the change amount ΔR3 and the change amount ΔR4 both have opposite signs to each other, the change amount ΔR3 and the change amount ΔR4 do not offset each other and thus increase or decrease appears in the numerator. This is because, by the application of the signal magnetic field Hm, the resistances of the second and the fourth MR elements 2 and 4 change by the change amounts ΔR2 and ΔR4 (ΔR2, ΔR4 < 0), respectively (i.e., the resistances thereof substantially decrease), whereas the resistances of the first and the third MR elements 1 and 3 change by the change amounts ΔR1 and ΔR3 (ΔR1, ΔR3 > 0), respectively (i.e., the resistance values thereof substantially increase).

When assuming that all of the first to the fourth MR elements 1 to 4 have completely the same characteristics, that is, if: r1 = r2 = r3 = r4 = R; and ΔR1 = - ΔR2 = ΔR3 = - ΔR4 =ΔR are established, the Equation (4) is expressed as follows.

$$V0 = \{(R + \Delta R) / (2 \cdot R) - (R - \Delta R) / (2 \cdot R)\} \times V$$

$$= (\Delta R / R) \times V \qquad \qquad \text{Equation (5)}$$

Consequently, it is possible to measure the magnitude of the signal magnetic field Hm based on the Equation (4) or the Equation (5), by using the first to the fourth MR elements 1 to 4 in which a relationship between the signal magnetic field Hm and the amounts of resistance changes ΔR (or ΔR1 to ΔR4) is known.

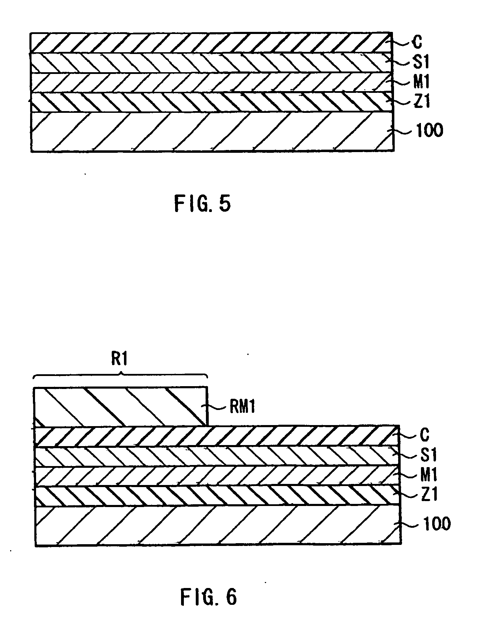

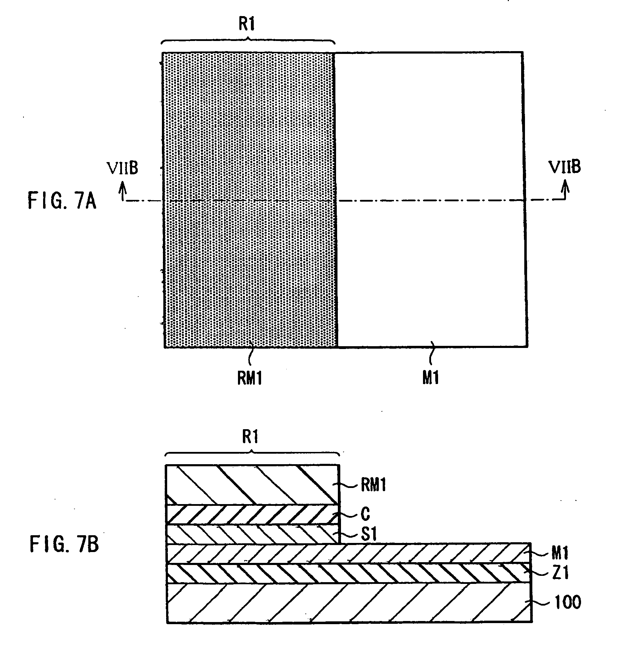

Now, a method of manufacturing the magnetic sensor will be described with reference to FIGs. 5 to 16B. FIGs. 5 to 16B each illustrate a region near a boundary between the first MR element 1 and the second MR element 2 in an expanded manner. FIGs. 7A to 16A are views as seen from above, and FIGs. 7B to 16B are cross-sectional views corresponding to sectional lines illustrated in FIGs. 7A to 16A, respectively.

Referring to FIG. 5, the substrate 100 which may be configured of the material described above is provided, and as needed, an insulating layer Z1 is provided on a surface of the substrate 100. Then, a metal film M1, which will eventually become the bottom electrodes 13, 23, 33, and 43, is so formed as to cover throughout a surface of the substrate 100 or the insulating layer Z1 by using a material such as copper. Further, an MR film S1, which will eventually become the stacked bodies 11 and 31, is so formed as to cover throughout a surface of the metal film M1. The MR film S1 is obtained by stacking the antiferromagnetic layer 64, the magnetization pinned layer 63, the spacing layer 62, and the magnetization free layer 61 sequentially on the metal film M1 by using a sputtering method and the materials described above, for example. Herein, the magnetization pinned layer 63 is so formed that an odd number of ferromagnetic films (not illustrated), which will eventually become the first and the second ferromagnetic layers 631 and 632, are included therein. For example, a ferromagnetic film, a nonmagnetic film, a ferromagnetic film, a nonmagnetic film, and a ferromagnetic film are subsequently stacked on the antiferromagnetic layer 64 to obtain the magnetization pinned layer 63. After forming the MR film S1, as needed, a hard mask such as a carbon may be so formed, as a protecting film C, to cover throughout a surface of the MR film S1.

Then, as illustrated in FIG. 6, a resist mask RM1 is so selectively formed as to cover only a region R1 in which the first MR element 1 and the third MR element 3 will eventually be formed. Then, as illustrated in FIGs. 7A and 7B, the protecting film C and the MR film S1 in an exposed region are so selectively removed as to leave the protecting film C and the MR film S1 in the region R1, by using a milling process. The milling process performed here finishes when the milling process reaches the metal film M1.

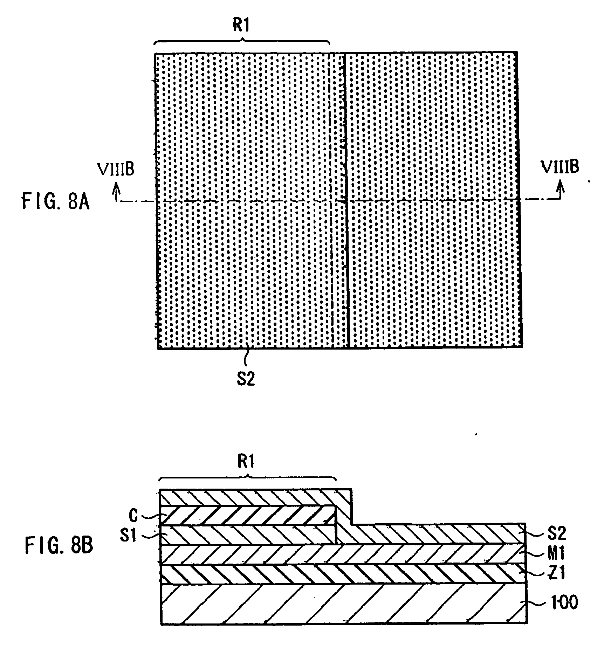

Then, the resist mask RM1 is dissolved to remove the same, and a MR film S2, which will eventually become the stacked bodies 21 and 41, is thereafter so formed as to cover throughout a surface as illustrated in FIGs. 8A and 8B. The MR film S2 may be formed by a process procedure similar to that of the MR film S1, for example. However, it is to be noted that the process procedure of the MR film S2 differs from that of the MR film S1, in that the magnetization pinned layer 63 is so formed that an even number of ferromagnetic films (not illustrated), which will eventually become the first and the second ferromagnetic layers 631 and 632, are included therein.

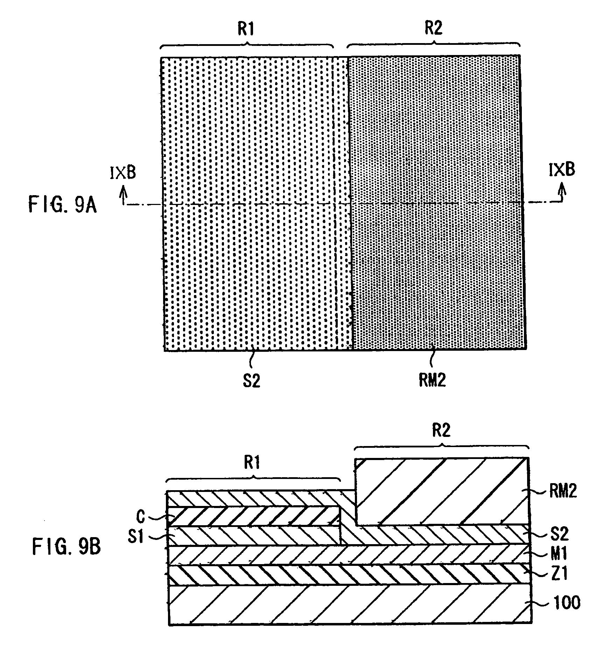

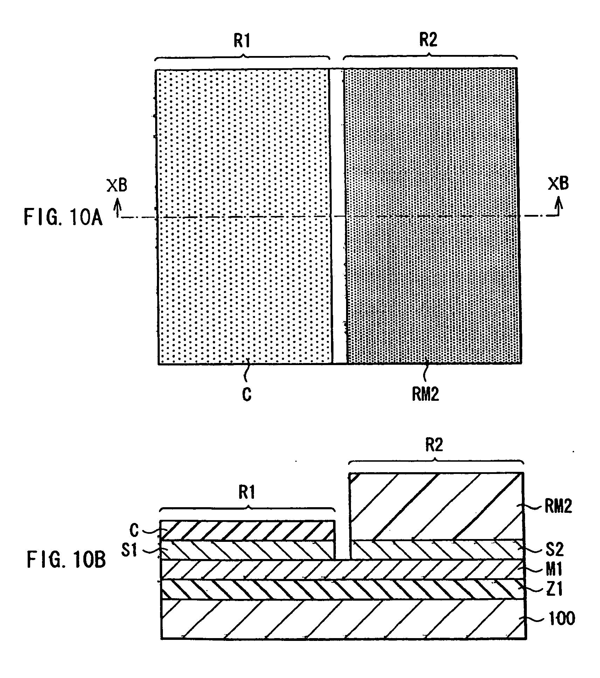

Then, after the MR film S2 is formed, a resist mask RM2 is so selectively formed as to cover only a region R2 in which the second MR element 2 and the fourth MR element 4 will eventually be formed, as illustrated in FIGs. 9A and 9B. Then, as illustrated in FIGs. 10A and 10B, the MR film S2 in an exposed region is so selectively removed as to leave the MR film S2 in the region R2, by using a milling process. The milling process performed here finishes when the milling process reaches the metal film M1 or the protecting film C.

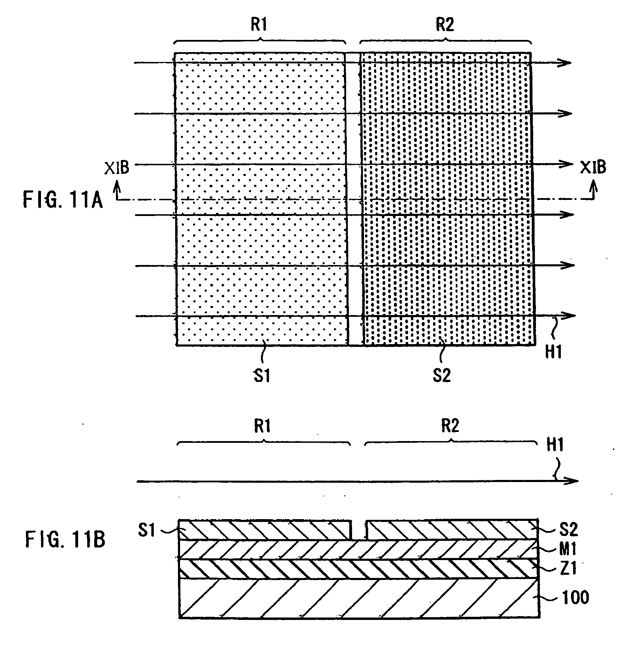

Then, as illustrated in FIGs. 11A and 11B, the resist mask RM2 is dissolved to remove the same, and the protecting film C is removed by using an ashing process. Thereafter, the annealing process is performed on the MR films S1 and S2. For example, a heating is performed on the MR films S1 and S2 at a predetermined temperature of 280 degrees centigrade while applying an applied magnetic field H1 in the plus Y direction, to allow the direction of the magnetization J631 and the direction of the magnetization J632 in the magnetization pinned layer 63 to be secured by one operation. Thus, a ferromagnetic layer adjacent to the antiferromagnetic layer 64 in all of the magnetization pinned

EP 2 302 406 B1

layers 63 among the stacked bodies 11, 21, 31, and 41 turns into the first ferromagnetic layer 631 having the magnetization J631 in the minus Y direction following the annealing process. More specifically, in the magnetization pinned layer 63 of the stacked bodies 11 and 31 including the odd number of ferromagnetic films, the first ferromagnetic layer 631B having the magnetization J631 in the minus Y direction is located at a position nearest to the antiferromagnetic layer 64, while the first ferromagnetic layer 631A also having the magnetization J631 in the minus Y direction is located at a position nearest to the magnetization free layer 61. Also, in the magnetization pinned layer 63 of the stacked bodies 11 and 31, the first ferromagnetic layers 631, each having the magnetization J631 in the minus Y direction, are provided more by one layer than the second ferromagnetic layer 632 having the magnetization J632 in the plus Y direction. On the other hand, in the magnetization pinned layer 63 of the stacked bodies 21 and 41 including the even number of ferromagnetic films, the same number of the first ferromagnetic layer 631 having the magnetization J631 in the minus Y direction and the second ferromagnetic layer 632 having the magnetization J632 in the plus Y direction are provided. Also, the first ferromagnetic layer 631 having the magnetization J631 in the minus Y direction is located at a position nearest to the antiferromagnetic layer 64, while the second ferromagnetic layer 632 having the magnetization J632 in the plus Y direction is located at a position nearest to the magnetization free layer 61. It is preferable, but not required, that the applied magnetic field H1 here have an intensity larger than that of an exchange coupling magnetic field in the synthetic structure of the magnetization pinned layer 63, that is, larger than the exchange coupling magnetic field between the first ferromagnetic layer 631 and the second ferromagnetic layer 632.

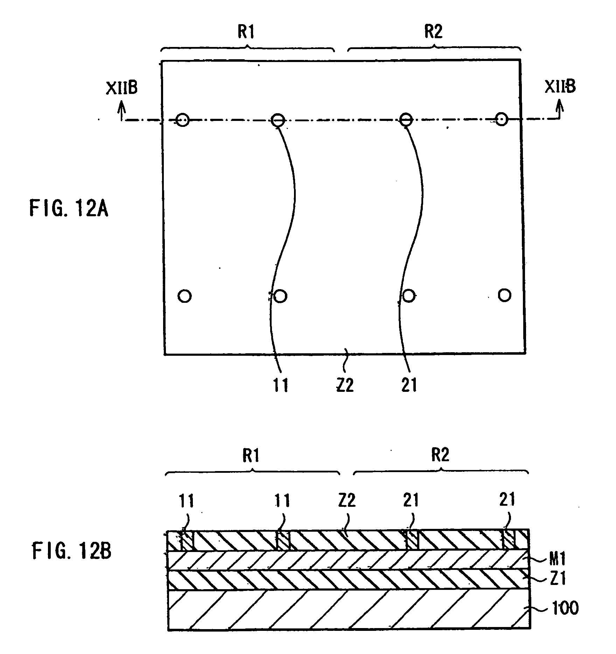

Then, as illustrated in FIGs. 12A and 12B, after performing the annealing process, the MR films S1 and S2 are patterned to form, at predetermined positions, the columnar stacked bodies 11, 21, 31, and 41 each having a predetermined planar configuration and size. Further, as illustrated in FIGs. 12A and 12B, an insulating layer Z2 is so formed as to embed around the columnar stacked bodies 11, 21, 31, and 41, by using a material such as $Al_2O_3$, for example. Incidentally, the stacked bodies 31 and 41 are not illustrated in FIGs. 12A and 12B. Also, although the MR films S1 and S2 are patterned after performing the annealing process in this embodiment, the patterning process of the MR films S1 and S2 and the annealing process may be reversed in order. In one embodiment, the MR films S1 and S2 are patterned to form the columnar stacked bodies 11, 21, 31, and 41, following which the annealing process is performed on those columnar stacked bodies 11, 21, 31, and 41.

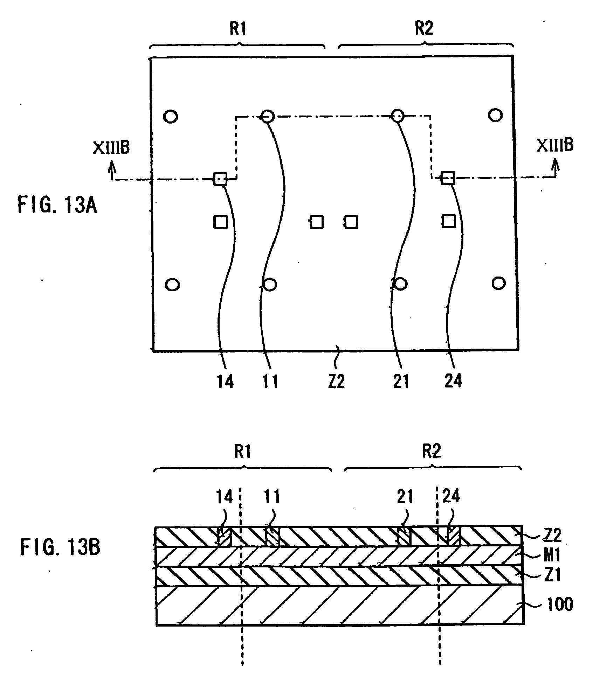

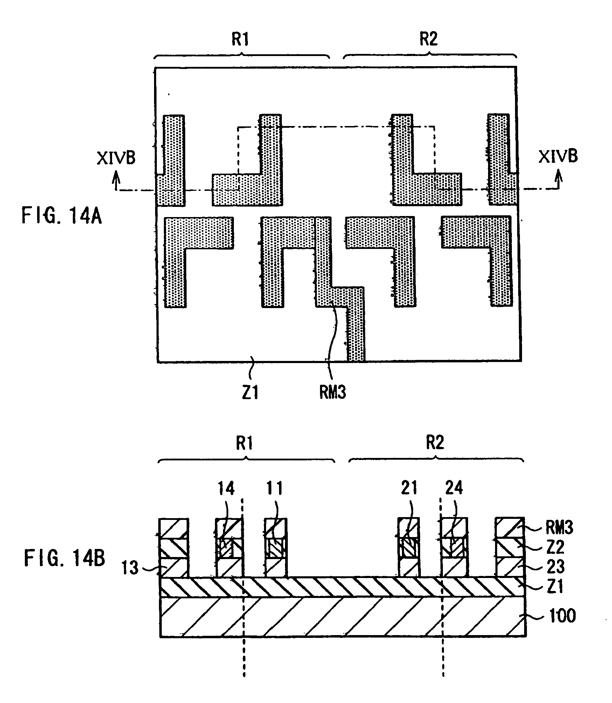

Then, as illustrated in FIGs. 13A and 13B, the connectors 14, 24, 34, and 44 are so formed as to stand at predetermined positions (the connectors 34 and 44 are not illustrated in FIGs. 13A and 13B). Then, as illustrated in FIGs. 14A and 14B, the stacked bodies 11 to 41, the connectors 14 to 44, and neighborhood regions thereof are selectively covered by a resist mask RM3, to perform a milling process on the metal film M1 located in unprotected regions. As a result, the bottom electrodes 13, 23, 33, and 43, and the interconnection L2 are obtained.

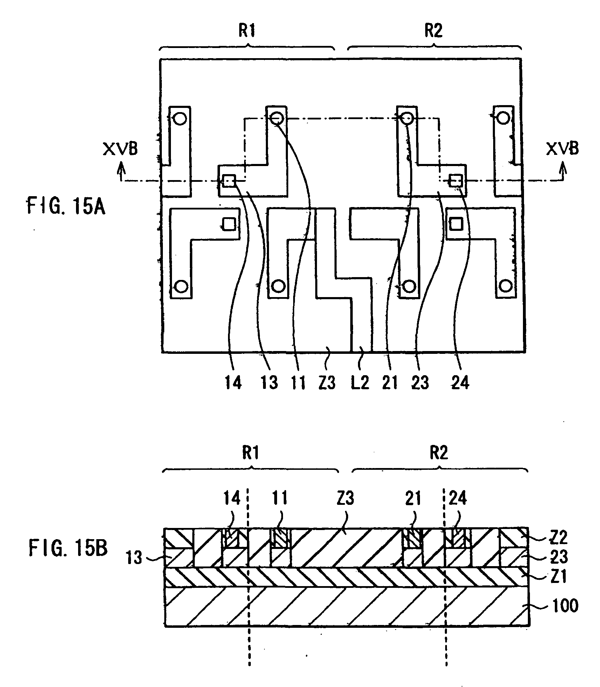

Then, as illustrated in FIGs. 15A and 15B, an insulating layer Z3 is so formed as to embed the regions in which the metal film M1 is removed by the milling process, by using material such as $Al_2O_3$, for example. Thereafter, the resist mask RM3 is dissolved to remove the same.

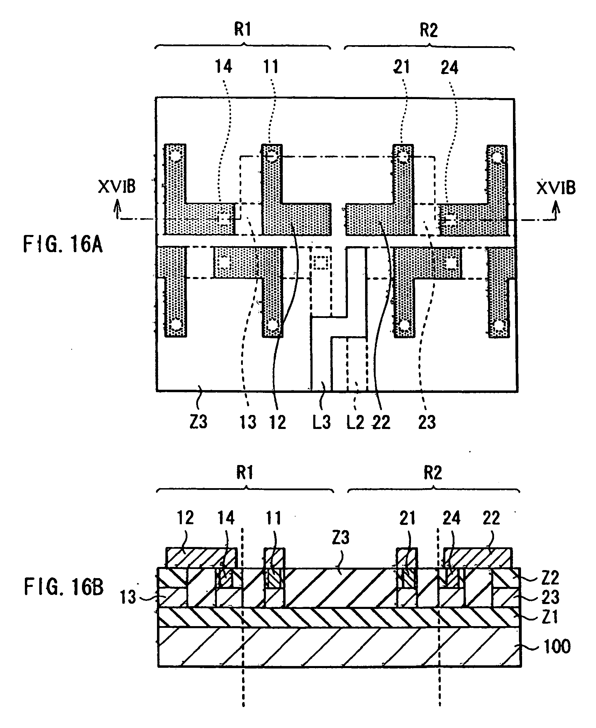

Then, as illustrated in FIGs. 16A and 16B, the top electrodes 12, 22, 32, and 42 (only the upper electrodes 12 and 22 are illustrated in FIGs. 16A and 16B), each having a predetermined shape, are so formed as to contact with the upper surface of the stacked bodies 11 to 41 and the upper surface of the connectors 14 to 44. Also, the interconnections L1 and L3 to L6 (only the interconnection L3 is illustrated in FIGs. 16A and 16B) are formed. Finally, a predetermined process, such as a forming process of the pads 51 to 54 and so forth, is performed to complete the magnetic sensor according to this embodiment.

Therefore, according to this embodiment, the numbers of the first ferromagnetic layers 631 and the second ferromagnetic layers 632, which are antiferromagnetically coupled to each other, are adjusted to allow each of the first and the third MR elements 1 and 3 and each of the second and the fourth MR elements 2 and 4 to exhibit the resistance changes in directions (i.e., increasing/decreasing direction) opposite to each other in response to the signal magnetic field Hm. Thus, the magnetic sensor according to this embodiment enables a compact configuration having the magnetic field detecting circuit including the first to the fourth MR elements 1 to 4 which are connected in a full-bridge configuration on the same substrate 100, and yet enables a high-accuracy detection of magnetic field. Also, the method of manufacturing the magnetic sensor according to this embodiment enables to manufacture the magnetic sensor with high degree of accuracy in a simplified fashion, since the magnetization directions of the magnetization pinned layer 63 are settable by performing the annealing process while applying the unidirectional applied magnetic field H1, without using special facilities such as a laser irradiation system, an electron beam irradiation system and so forth.

It is to be understood that the above description is intended to be illustrative and not restrictive. Many embodiments and modifications will be apparent to those of skill in the art upon reviewing the above description. For example, in the embodiment described above, the detection circuit including the four MR elements (i.e., a full-bridge circuit) is used to detect the signal magnetic field, although it is not limited thereto. In one embodiment, a detection circuit provided with the first and the second MR elements, exhibiting resistance changes in directions (i.e., increasing/decreasing direction) opposite to each other in response to a signal magnetic field (i.e., a so-called half-bridge circuit) may be used to detect the signal magnetic field.

Also, in the embodiment described above, the description has been given with reference to a tunnel MR element having a magnetic tunnel junction structure as the MR element. However, a current-in-plane (CIP) or a current-perpendicular-to-plane (CPP) GMR element may be employed in one embodiment, where the spacing layer may be replaced by a nonmagnetic material layer having high-electrical conductivity, such as copper (Cu), gold (Au), chromium (Cr), and so forth, instead of the tunnel barrier layer, for example.

Further, in the embodiment described above, the description has been given with reference to the magnetic sensor which detects the magnitude of the signal magnetic field applied in one given direction, although it is not limited thereto. The magnetic sensor according to the embodiment may be utilized as an angle sensor which detects an orientation or direction of a signal magnetic field rotating in a certain plane of rotation (a plane parallel to the lamination plane of the MR elements). In this one embodiment, since an amount of resistance change varies depending on a relative angle between a direction of application of the signal magnetic field and an orientation of magnetization of the magnetization pinned layer in each of the MR elements as long as a magnitude of the signal magnetic field is constant, this relationship is utilized to obtain an angle of rotation of the signal magnetic field.

It should be appreciated that variations may be made in the described embodiments by persons skilled in the art without departing from the scope of the invention as defined by the following claims. The limitations in the claims are to be interpreted broadly based on the language employed in the claims and not limited to examples described in the specification or during the prosecution of the application, and the examples are to be construed as non-exclusive. For example, in the disclosure, the term "preferably", "preferred" or the like is non-exclusive and means "preferably", but not limited to. The use of the terms first, second, etc. do not denote any order or importance, but rather the terms first, second, etc. are used to distinguish one element from another. Moreover, no element or component in the disclosure is intended to be dedicated to the public regardless of whether the element or component is explicitly recited in the following claims.

This application is based on and claims priority from Japanese Patent Application No. 2009-217926, filed in the Japan Patent Office on September 18, 2009.

## Claims

1. A method of manufacturing a magnetic sensor, comprising the steps of:

   selectively forming, on a substrate, a first magnetoresistive element (1) and a second magnetoresistive element (2) in respective regions different from each other,
   the first magnetoresistive element (1) and the second magnetoresistive element (2) each including, in order:

   an antiferromagnetic layer (64);
   a magnetization pinned layer (63) having a plurality of ferromagnetic layers which are antiferromagnetically coupled to each other with a nonmagnetic coupling layer in between;
   a nonmagnetic spacing layer; and
   a magnetization free layer (61) in which orientation of magnetization changes in response to a signal magnetic field; and
   heating the first magnetoresistive element (1) and the second magnetoresistive element (2) while applying thereto a magnetic field in one given direction, thereby allowing orientation of magnetization in all of the plurality of ferromagnetic layers of the magnetization pinned layers in the first magnetoresistive element (1) and the second magnetoresistive element (2) to be secured by one operation,
   wherein the magnetization pinned layer (63) in the first magnetoresistive element (1) is so formed as to include the odd number of the ferromagnetic layers, and
   the magnetization pinned layer (63) in the second magnetoresistive element (2) is so formed as to include the even number of the ferromagnetic layers.

2. The method of manufacturing the magnetic sensor according to claim 1, wherein the magnetization pinned layer (63) in the first magnetoresistive element (1) is formed to have a five-layer structure including a first ferromagnetic layer having magnetization in a first direction as one of the plurality of ferromagnetic layers, a first coupling layer, a second ferromagnetic layer having magnetization in a second direction opposite to the first direction as another one of the plurality of ferromagnetic layers, a second coupling layer, and a third ferromagnetic layer having magnetization in a first direction as still another one of the plurality of ferromagnetic layers, and
   the magnetization pinned layer (63) in the second magnetoresistive element (2) is formed to have a three-layer structure including a fourth ferromagnetic layer having magnetization in a second direction as still another one of the plurality of ferromagnetic layers, a third coupling layer, and a fifth ferromagnetic layer having

magnetization in a first direction as still another one of the plurality of ferromagnetic layers, which are arranged in order from the magnetization free layer (61).

## Patentansprüche

**1.** Verfahren zum Herstellen eines Magnetsensors, das die folgenden Schritte enthält:

wahlweises Bilden eines ersten magnetoresistiven Elements (1) und eines zweiten magnetoresistiven Elements (2) auf einem Substrat in jeweils voneinander verschiedenen Bereichen,
wobei das erste magnetoresistive Element (1) und das zweite magnetoresistive Element (2) jeweils in dieser Reihenfolge enthalten:

eine antiferromagnetische Schicht (64);
eine Schicht (63) mit fester Magnetisierung, die mehrere ferromagnetische Schichten besitzt, die antiferromagnetisch miteinander gekoppelt sind, wobei sich dazwischen eine nicht magnetische Kopplungsschicht befindet;
eine nicht magnetische Abstandshalterschicht; und
eine Schicht (61) ohne Magnetisierung, in der sich die Orientierung der Magnetisierung als Reaktion auf ein Signalmagnetfeld ändert; und
Erwärmen des ersten magnetoresistiven Elements (1) und des zweiten magnetoresistiven Elements (2), während an sie ein Magnetfeld in einer gegebenen Richtung angelegt wird, um dadurch zu ermöglichen, dass die Orientierung der Magnetisierung in allen der mehreren ferromagnetischen Schichten der Schichten mit fester Magnetisierung in dem ersten magnetoresistiven Element (1) und dem zweiten magnetoresistiven Element (2) durch einen einzigen Vorgang fixiert wird,
wobei die Schicht (63) mit fester Magnetisierung in dem ersten magnetoresistiven Element (1) so geformt ist, dass sie die ungerade Anzahl der ferromagnetischen Schichten enthält, und
die Schicht (63) mit fester Magnetisierung in dem zweiten magnetoresistiven Element (2) so geformt ist, dass sie die gerade Anzahl der ferromagnetischen Schichten enthält.

**2.** Verfahren zum Herstellen des Magnetsensors nach Anspruch 1, wobei die Schicht (63) mit fester Magnetisierung in dem ersten magnetoresistiven Element (1) so geformt ist, dass sie eine fünflagige Struktur besitzt, die eine erste ferromagnetische Schicht mit einer Magnetisierung in einer ersten Richtung als eine der mehreren ferromagnetischen Schichten, eine erste Kopplungsschicht, eine zweite ferromagnetische Schicht mit einer Magnetisierung in einer zu der ersten Richtung entgegengesetzten zweiten Richtung als eine weitere der mehreren ferromagnetischen Schichten, eine zweite Kopplungsschicht und eine dritte ferromagnetische Schicht mit einer Magnetisierung in einer ersten Richtung als eine nochmals weitere der mehreren ferromagnetischen Schichten enthält; und
die Schicht (63) mit fester Magnetisierung in dem zweiten magnetoresistiven Element (2) so geformt ist, dass sie eine dreilagige Struktur besitzt, die eine vierte ferromagnetische Schicht mit einer Magnetisierung in einer zweiten Richtung als eine nochmals weitere der mehreren ferromagnetischen Schichten, eine dritte Kopplungsschicht und eine fünfte ferromagnetische Schicht mit einer Magnetisierung in einer ersten Richtung als eine nochmals weitere der mehreren ferromagnetischen Schichten enthält, die in dieser Reihenfolge ausgehend von der magnetisierungsfreien Schicht (61) angeordnet sind.

## Revendications

**1.** Procédé de fabrication d'un capteur magnétique, comprenant les étapes de :

formation sélective, sur un substrat, d'un premier élément magnétorésistif (1) et d'un second élément magnétorésistif (2) dans des zones respectives différentes l'une de l'autre,
le premier élément magnétorésistif (1) et le second élément magnétorésistif (2) comportant chacun dans l'ordre :

une couche antiferromagnétique (64) ;
une couche piégée de magnétisation (63) comprenant plusieurs couches ferromagnétiques qui sont couplées de manière antiferromagnétique les unes aux autres avec une couche de couplage non magnétique entre elles ;
une couche d'espacement non magnétique ; et

une couche libre de magnétisation (61) dont l'orientation de magnétisation change en réponse à un champ magnétique de signal ; et

chauffage du premier élément magnétorésistif (1) et du second élément magnétorésistif (2) tout en appliquant à ces derniers un champ magnétique dans un sens donné, permettant de ce fait l'orientation de magnétisation dans la totalité des couches ferromagnétiques des couches piégées de magnétisation dans le premier élément magnétorésistif (1) et au second élément magnétorésistif (2) d'être fixé par une seule opération,

dans lequel la couche piégée de magnétisation (63) dans le premier élément magnétorésistif (1) est formée de façon à comporter le nombre impair des couches ferromagnétiques, et

la couche piégée de magnétisation (63) dans le second élément magnétorésistif (2) est formée de façon à comporter le nombre pair des couches ferromagnétiques.

2. Procédé de fabrication du capteur magnétique selon la revendication 1, dans lequel la couche piégée de magnétisation (63) dans le premier élément magnétorésistif (1) est formée pour avoir une structure à cinq couches comportant une première couche ferromagnétique présentant une magnétisation dans un premier sens comme une des plusieurs couches ferromagnétiques, une première couche de couplage, une deuxième couche ferromagnétique présentant une magnétisation dans un second sens opposé au premier sens comme une autre des plusieurs couches ferromagnétiques, une deuxième couche de couplage, et une troisième couche ferromagnétique présentant une magnétisation dans un premier sens comme encore une autre des plusieurs couches ferromagnétiques, et

la couche piégée de magnétisation (63) dans le second élément magnétorésistif (2) est formée pour avoir une structure à trois couches comportant une quatrième couche ferromagnétique présentant une magnétisation dans un second sens comme encore une autre couche des plusieurs couches ferromagnétiques, une troisième couche de couplage, et une cinquième couche ferromagnétique présentant une magnétisation dans un premier sens comme encore une autre couche des plusieurs couches ferromagnétiques, qui sont agencées dans l'ordre à partir de la couche libre de magnétisation (61).

FIG. 1

EP 2 302 406 B1

FIG. 2

FIG. 3A

J61

61

62

631A
633
632     } 63
633
631B

64

J631     J632

FIG. 3B

J61

61

62

632
}
633     } 63
631

64

J632     J631

11, 31

21, 41

Z
↑
X⊗——→Y

F I G. 4

C
S1
M1
Z1
100

**FIG. 5**

R1

RM1
C
S1
M1
Z1
100

**FIG. 6**

R1

FIG. 7A

VIIB               VIIB

RM1              M1

R1

FIG. 7B

RM1
C
S1
M1
Z1
100

FIG. 8A

R1

VIIIB

S2

FIG. 8B

R1

C
S1

S2
M1
Z1
100

FIG. 9A

R1 R2

IXB IXB

S2 RM2

FIG. 9B

R2

R1

RM2

C
S1
S2
M1
Z1
100

FIG. 10A

R1

R2

XB

XB

C

RM2

FIG. 10B

R1

R2

C
S1

RM2
S2
M1
Z1
100

R1                    R2

XIB                              XIB

FIG. 11A

S1                    S2

H1

R1                    R2        H1

FIG. 11B    S1                          S2
                                        M1
                                        Z1
                                        100

FIG. 12A

FIG. 12B

FIG. 13A

R1          R2

XIIIB                    XIIIB

14  11  Z2  21  24

FIG. 13B

R1          R2

14  11      21  24

Z2
M1
Z1
100

R1　　　　　　R2

XIVB　　　　　　　　　　　　　　　　　　　XIVB

FIG. 14A

Z1　　RM3

R1　　　　　　R2

14　　11　　　　21　　24

FIG. 14B　13　　　　　　　　　　　　　　　RM3
Z2
23
Z1
100

FIG. 15A

R1    R2

XVB    XVB

14  13  11  Z3  L2  21  23  24

FIG. 15B

R1    R2

14  11    Z3    21  24

13    Z2
23
Z1
100

FIG. 16A

FIG. 16B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5621377 A
- JP 2008111801 A
- JP 2003502674 A
- JP 2003502876 A
- US 6771472 B1
- US 20090190272 A1
- JP 2009217926 A